# EUROPÄISCHE PATENTSCHRIFT

(11) **EP 1 046 221 B1**
(45) Veröffentlichungstag und Bekanntmachung des Hinweises auf die Patenterteilung: **21.05.2003**
(21) Anmeldenummer: 98966229.1
(22) Anmeldetag: 29.12.1998
(51) Int. Cl.: H03B 5/18

(54) **OSZILLATORSTRUKTUR MIT WENIGSTENS EINEM OSZILLATOR-SCHALTKREIS UND WENIGSTENS EINEM RESONATOR**
OSCILLATOR STRUCTURE WITH AT LEAST ONE OSCILLATOR CIRCUIT AND AT LEAST ONE RESONATOR
STRUCTURE D'OSCILLATEUR PRESENTANT AU MOINS UN CIRCUIT OSCILLATEUR ET AU MOINS UN RESONATEUR

(30) Priorität: 08.01.1998 DE 19800459
(43) Veröffentlichungstag der Anmeldung: 25.10.2000
(73) Patentinhaber: Infineon Technologies AG, 81669 München (DE)
(72) Erfinder: SCHÖPF, Klaus-Jürgen, Chandler, AZ 85225 (US); LOHNINGER, Gerhard, D-81549 München (DE); MUSIOL, Lothar, D-81735 München (DE)
(74) Vertreter: Müller - Hoffmann & Partner
(86) Internationale Anmeldenummer: DE9803803
(87) Internationale Veröffentlichungsnummer: WO99035735

(56) Entgegenhaltungen:
- US-A- 5 140 286
- US-A- 5 227 739
- US-A- 5 357 218
- KALTENECKER R S ET AL: "INTERNAL ISOLATION RINGS IMPROVE VCO PERFORMANCE" MOTOROLA TECHNICAL DEVELOPMENTS, Bd. 16, Nr. 8, 1. August 1992, Seiten 70-71, XP000310358
- KAMOGAWA K ET AL: "WIDE-TUNNING RANGE SI BIPOLAR VCO'S BASED ON THREE-DIMENSIONAL MMICTECHNOLOGY" IEEE TRANSACTIONS ON MICROWAVE THEORY AND TECHNIQUES, Bd. 45, Nr. 12, PART 02, 1. Dezember 1997, Seiten 2436-2443, XP000732031

## Beschreibung

Die Erfindung betrifft eine Oszillatorstruktur mit wenigstens einem Oszillator-Schaltkreis und wenigstens einem Resonator.

Oszillatoren sind elektronische Schwingungserzeuger, d.h. Schaltungen zum Erzeugen von elektrischen Schwingungen. Die elektrischen Schwingungen haben in der Regel einen sinusförmigen Verlauf. Jedoch ist auch ein anderer zeitlicher Verlauf, beispielsweise in Form einer Rechteck-, Sägezahn-, Dreiecks- oder Deltaform möglich. Die Oszillatoren enthalten einen Verstärker und wenigstens ein Rückkopplungsmittel. Dieses Rückkopplungsmittel bewirkt, daß ein Teil des Ausgangssignals des Verstärkers an seinen Eingang zurückgekoppelt wird.

Eine Vielzahl von elektronischen Geräten enthält einen Oszillator. Neben Signalgeneratoren, Funktionsgeneratoren und Impulsgeneratoren sind insbesondere Sender und Empfänger im Hochfrequenz- bis Mikrowellenbereich von Interesse.

Bei einer gattungsgemäßen Oszillatorstruktur kann es sich insbesondere um einen spannungsgesteuerten Oszillator VCO (Voltage Controlled Oscillator) handeln, der durch einen Resonator stabilisiert wird.

Ein VCO weist die Besonderheit auf, daß seine Frequenz durch eine an ihm anliegende Spannung gesteuert werden kann. Zur Stabilisierung des Oszillators dient ein Resonator. VCOs eignen sich sowohl für Logikschaltungen als auch für Hochfrequenzanwendungen. Bei einem Einsatz im Hochfrequenzbereich kann eine Abstimmung des Schwingungsverhaltens beispielsweise durch eine Varaktordiode erfolgen. Hierdurch kann die Oszillatorstruktur im Giga-Hertz-Bereich eingesetzt werden.

Die bekannten Oszillatorstrukturen haben sich in der Praxis vielfältig bewährt. Die großen Abmessungen der Oszillatorstruktur sind jedoch nachteilig.

Der Erfindung liegt die Aufgabe zugrunde, die Nachteile des Standes der Technik zu vermeiden. Insbesondere soll eine Oszillatorstruktur geschaffen werden, die ein möglichst geringes Volumen beansprucht. Ferner sollte die Oszillatorstruktur in ein Gehäuse integrierbar sein. Derartige Strukturen werden z.B. in US-A-5 227 739 oder US-A-5 140 286 beschrieben.

Erfindungsgemäß wird diese Aufgabe bei einer gattungsgemäßen Oszillatorstruktur dadurch gelöst, daß der Oszillator-Schaltkreis auf einem Träger angeordnet ist, und daß der Resonator sich innerhalb des Trägers befindet und/oder ein Bestandteil des Trägers ist.

Die Erfindung sieht also vor, die Oszillatorstruktur so auszugestalten, daß der Oszillator-Schaltkreis und der Resonator voneinander räumlich getrennt sind. Hierdurch ist es möglich, daß der Oszillator-Schaltkreis möglichst kleine Abmessungen aufweist, und daß gleichzeitig ein für die erforderlichen elektrischen Eigenschaften ausreichend großer Resonator geschaffen werden kann.

Eine weitere Verringerung des Platzbedarfs für die Oszillatorstruktur wird dadurch erzielt, daß der Resonator sich innerhalb eines Trägers für den Oszillator-Schaltkreis befindet und/oder ein Bestandteil dieses Trägers ist.

Die Anordnung des Oszillator-Schaltkreises auf einem Träger, der den Resonator schon enthält, führt dazu, daß die Abmessungen der Oszillatorstruktur sehr klein gehalten werden können.

Während der Resonator aus einem elektrisch leitfähigen Material besteht, kann der Träger leitend oder nichtleitend sein. Der Begriff Träger ist in keiner Weise einschränkend zu verstehen. Insbesondere ist hierunter jede Halterung oder Unterlage für den Oszillator-Schaltkreis zu verstehen.

Der Träger kann beispielsweise auch durch eine Folie gebildet sein. In diesem Fall ist es zweckmäßig, daß der Leiter durch eine auf die Folie aufgebrachte Metallisierungsschicht gebildet wird. Eine derartige Metallisierungsschicht kann auch dann eingesetzt werden, wenn der Träger aus einem Kunststoff- oder Keramik-Substrat besteht.

Der Träger kann auch aus einem Metall bestehen und beispielsweise als gestanzter Blechstreifen (Leadframe) ausgeführt sein.

Die Erfindung bezieht sich insbesondere auch auf die Integration der Oszillatorstruktur auf dem Träger in ein Gehäuse, insbesondere als ein Bauteil.

Hierbei wird der Träger in einer Gehäuseebene, vorzugsweise im unteren Bereich des Gehäuses, angeordnet. Auf diesem Träger befindet sich der Oszillator-Schaltkreis.

Eine weitere Verringerung des erforderlichen Platzes läßt sich dadurch erreichen, daß der unter dem Oszillator-Schaltkreis liegende Teil des leitenden Trägers mindestens einen elektrischen Leiter enthält.

Vorzugsweise weist der elektrische Leiter eine Streifenform auf. Auch andere Strukturen des elektrischen Leiters, wie zum Beispiel eine Mäanderform oder eine Spiralform sind zweckmäßig, wobei die gewählte Form der Frequenz angepaßt wird.

Die Gestaltung des elektrischen Leiters als freigelegter Teil eines leitenden Trägers, der auf einer Seite mit dem Träger verbunden ist, hat den besonderen Vorteil, daß ein unter dem Oszillator-Schaltkreis liegender Teil der Fläche des Trägers unmittelbar für die Ausbildung eines elektrischen Resonanzkreises genutzt werden kann. In diesem Fall stellt der freigelegte Leiter im elektrischen Ersatzschaltbild eine durch seine mechanischen Abmessungen definierte Induktivität mit einem parallel geschalteten Widerstand dar. Vorzugsweise ist der elektrische Leiter an einer Stelle mit einem Erdpotential verbunden. Dies geschieht beispielsweise über den vorzugsweise als Trägerfläche ausgebildeten Träger. An einer anderen Stelle ist der elektrische Leiter mit einer Kapazität elektrisch verbunden.

Diese Ausführungsform kann zur weiteren Verbesserung ihrer elektrischen Eigenschaften so ausgestaltet werden, daß das eine Ende des vorzugsweise streifenförmigen elektrischen Leiters an dem Träger angeordnet ist, und daß das andere Ende des elektrischen Leiters als Koppelpunkt zum Ein- oder Auskoppeln eines elektrischen Signals dient.

Es ist besonders zweckmäßig, daß der elektrische Leiter sich im wesentlichen innerhalb einer leitenden Trägerfläche befindet. Eine derartige Anordnung hat den Vorteil, daß der Einfluß äußerer Störfelder weitgehend verringert wird.

Eine weitere Verringerung des Platzbedarfes kann dadurch erzielt werden, daß der Oszillator-Schaltkreis durch eine integrierte elektronische Schaltung gebildet wird.

Hierbei ist es besonders zweckmäßig, daß die integrierte elektronische Schaltung wenigstens eine Varaktordiode enthält.

Bei einer Varaktordiode handelt es sich um eine Flächenkontaktdiode mit einem pn-Übergang, an dem sich eine Sperrschicht ausbildet, die mit einer Steuerspannung in Sperrichtung variiert werden kann. Die isolierende Sperrschicht bildet mit den leitenden Deckflächen einen Kondensator, dessen Fläche konstant bleibt, und dessen Plattenabstand mit der Steuerspannung verändert werden kann. Eine Varaktordiode zeichnet sich vorzugsweise durch ein großes Verhältnis zwischen der größten und der kleinsten nutzbaren Kapazität, einen niedrigen Serienwiderstand und damit eine hohe Güte aus. Durch den Einsatz einer Varaktordiode enthält die integrierte elektronische Schaltung somit einen spannungsgesteuerten, veränderbaren Kondensator. Hierdurch wird die Eigenfrequenz des Resonators gesteuert.

Die Varaktordiode kann aus verschiedenen Grundmaterialien gebildet werden. Neben dem technologisch besonders leicht handhabbaren Silizium eignet sich für hohe Frequenzen besonders Galliumarsenid. Bei Galliumarsenid ist die Beweglichkeit der Ladungsträger ungefähr viermal größer als in Silizium, entsprechend kleiner ist der Serienwiderstand der Varaktordiode.

Ein Verstärker zur Anregung der elektrischen Schwingung kann an einer beliebigen Stelle angeordnet sein, es ist jedoch besonders zweckmäßig, daß der Verstärker in die integrierte elektronische Schaltung eingebaut ist.

Vorzugsweise ist der Verstärker zusammen mit der Varaktordiode eingebaut.

Es ist grundsätzlich möglich, den Oszillator-Schaltkreis, der vorzugsweise durch eine integrierte elektronische Schaltung gebildet wird, auf eine beliebige Weise mit dem Träger mechanisch zu verbinden. Es ist jedoch besonders zweckmäßig, daß die integrierte elektronische Schaltung über eine Klebeschicht mit dem Trager verbunden ist. Eine Verbindung über eine Klebeschicht weist mehrere Vorteile auf. Eine derartige Verbindung ist sehr einfach herstellbar. Außerdem ist es möglich, daß die Klebeschicht die integrierte elektronische Schaltung von einem Träger und/oder einem Resonator isoliert. Die Verbindung über eine Klebeschicht ist besonders dann zweckmäßig, wenn die elektronische Schaltung in der Form eines Chips vorliegt. Dann ist es vorteilhaft, daß der Chip keine Rückseitenmetallisierung aufweist.

Besonders zweckmäßig ist es, daß die integrierte elektronische Schaltung über einen Verbindungsdraht (Bonddraht) mit dem vorzugsweise leitenden Träger verbunden ist.

Es ist besonders vorteilhaft, daß ein Verbindungsdraht mit dem Koppelpunkt eines freigelegten elektrischen Leiters verbunden ist.

Weitere Vorteile, Besonderheiten und zweckmäßige Weiterbildungen der Erfindung ergeben sich aus den Unteransprüchen sowie der nachfolgenden Beschreibung bevorzugter Ausführungsbeispiele anhand der Zeichnungen.

Von den Zeichnungen zeigt
- **Fig. 1**: ein Gehäuse mit einem Träger, der einen freigelegten elektrischen Leiter enthält und
- **Fig. 2**: die in **Fig. 1** dargestellte Anordnung mit einem durch eine integrierte elektronische Schaltung gebildeten Oszillator.

Die Darstellung bezieht sich auf ein Ausführungsbeispiel einer erfindungsgemäßen Oszillatorstruktur in einem handelsüblichen IC-Gehäuse wie dem Gehäuse der Bauform SCT596.

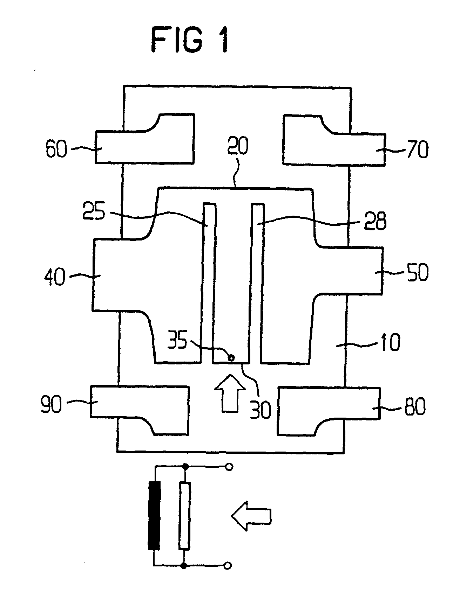

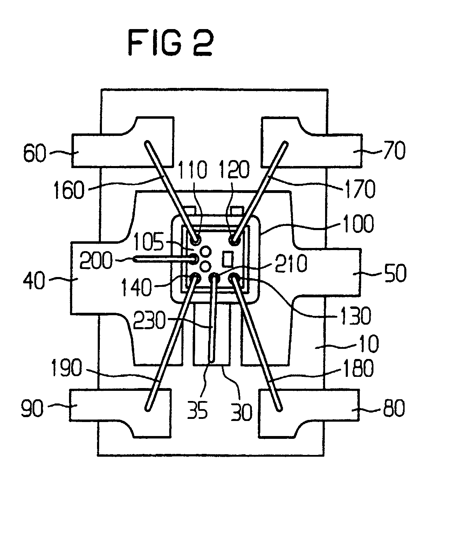

Die Figuren 1 und 2 zeigen, wie sich in einem Gehäuse 10 ein Träger 20, der beispielsweise ein gestanzter Blechstreifen (Leadframe) ist, und weitere Anschlüsse 60, 70, 80 und 90, die vorzugsweise aus Metall bestehen, befinden. Die Flächenausdehnung des Trägers 20 liegt in der Größenordnung von 1 mm².

Das Gehäuse 10 besteht vorzugsweise aus einer Kunststoff-Preßmasse auf Epoxydharz-Basis mit einer Dielektrizitätskonstante im Bereich von 3 bis 5.

Bei dem als Träger 20 bezeichneten Metallstück und den Anschlüssen 60, 70, 80 und 90, die gleichfalls flächenförmig ausgebildet sind, handelt es sich vorzugsweise um ein Leadframe zur Halbleitermontage, aus dem die hier beschriebenen Strukturen ausgestanzt wurden. Der Träger 20 weist Ausnehmungen 25 und 28 auf, zwischen denen ein zungenförmig ausgebildeter elektrischer Leiter 30 freigelegt ist. Der elektrische Leiter 30 kann hier auch als Leiterstreifen bezeichnet werden. Der elektrische Leiter 30 weist vorzugsweise eine Länge in der Größenordnung von 1 mm auf. Beispielsweise betragen die Abmessungen des elektrischen Leiters 30: 800 µm x 250 µm.

Der elektrische Leiter 30 steht auf einer Seite mit dem Träger 20 in Kontakt. Auf der gegenüberliegenden Seite des elektrischen Leiters 30 befindet sich im Bereich eines Koppelpunktes 35 eine Vorrichtung zum Ein- oder Auskoppeln eines elektrischen Signals.

Der planar ausgebildete Träger 20 enthält in seinem Seitenbereich Kontakte 40 und 50, die zum Anschluß eines Erdpotentials dienen. Die Kontakte 40 und 50 befinden sich gleichfalls in der Ebene der Hauptfläche des Trägers 20, jedoch senkrecht zu dem elektrischen Leiter 30. Die Kontakte 40 und 50 sind verschieden gestaltet, um eine Kennzeichnung gegen Verdrehen um 180° zu erhalten. Beide Kontakte 40, 50 werden aber in gleicher Weise auf Masse gelötet.

Die Resonanzfrequenz des als Resonator wirkenden elektrischen Leiters 30 ergibt sich aus der Länge des elektrischen Leiters 30 und der Dielektrizitätskonstanten des Gehäuses. Die Dielektrizitätskonstante des Gehäuses liegt im Bereich von 2 bis 6, wobei 4 ein üblicher Wert ist.

Durch die Anschlüsse 60, 70, 80 und 90 können eine Versorgungsspannung, eine Oszillator-Steuerspannung, die sogenannte VCO - Abstimmspannung angelegt sowie ein Signalausgang und Anschlußmöglichkeiten für externe Schaltungselemente geschaffen werden. Es ist zweckmäßig, einen Erdungskondensator anzuschließen und so Störeinflüsse abzublocken.

Nachfolgend wird anhand von **Fig. 2** erläutert, wie die zuvor anhand von **Fig. 1** dargestellte Trägerstruktur durch das Hinzufügen einer integrierten elektrischen Schaltung zu einer Oszillatorstruktur vervollständigt wird.

Eine integrierte elektronische Schaltung 105 ist über eine isolierende Klebeschicht 100 mit dem Träger 20 verbunden. Ausgewählte Bereiche ("Bondpads") 110, 120, 130 und 140 der integrierten elektronischen Schaltung 105 sind über Verbindungsdrähte 160, 170, 180 und 190 mit den Anschlüssen 60, 70, 80 und 90 verbunden. Hierdurch kann an die ausgewählten Bereiche 110, 120, 130 und 140 der integrierten elektronischen Schaltung 105 eine Versorgungsspannung oder eine Oszillator-Steuerspannung angelegt werden. Ferner werden so Anschlußmöglichkeiten für externe Schaltungselemente geschaffen.

Über einen weiteren Verbindungsdraht 200 ist die integrierte elektronische Schaltung 105 unmittelbar mit dem Kontakt 40 der Trägerplatte 20 und damit mit dem Erdpotential verbunden.

Ein anderer ausgewählter Bereich 210 der integrierten elektronischen Schaltung ist über einen Verbindungsdraht 230 mit dem Koppelpunkt 35 am freien Ende des elektrischen Leiters 30 verbunden.

Die zuvor dargestellte Oszillatorstruktur vereint die Vorteile einer Integrierbarkeit in ein Gehäuse, vorzugsweise ein Kunststoffgehäuse, mit hervorragenden elektrischen Eigenschaften wie beispielsweise einer abstimmbaren Kapazität und einer möglichst geringen Beeinflußung durch äußere Störfelder.

Dieser Aufbau der erfindungsgemäßen Oszillatorstruktur ist besonders vorteilhaft. Es ist jedoch gleichfalls möglich, die Oszillatorstruktur auf eine andere Weise aufzubauen, so daß die Oszillatorstruktur beispielsweise direkt auf eine Leiterplatte oder -folie, auf einem Hybrid-Substrat oder in ein Mikrosystem integriert wird.

## Patentansprüche

1. Oszillatorstruktur mit wenigstens einem Oszillator-Schaltkreis (105) und wenigstens einem Resonator, wobei der Oszillator-Schaltkreis auf einem leitenden Träger (20) angeordnet ist und der Resonator, der Bestandteil des Trägers ist, durch einen freigelegten elektrischen Leiter (30) gebildet ist,
**dadurch gekennzeichnet,**
**daß** der den Resonator bildende elektrische Leiter (30) unter dem Oszillator-Schaltkreis (105) angeordnet ist.

2. Oszillatorstruktur nach Anspruch 1,
**dadurch gekennzeichnet,**
**daß** der Träger (20) eine Trägerfläche ist und daß der elektrische Leiter (30) sich im wesentlichen innerhalb der Trägerfläche befindet.

3. Oszillatorstruktur nach Anspruch 1 oder 2,
**dadurch gekennzeichnet,**
**daß** ein Ende des elektrischen Leiters (30) mit dem Träger (20) verbunden ist, und daß ein anderes Ende des elektrischen Leiters (30) als Koppelpunkt (35) zum Einoder Auskoppeln eines elektrischen Signals dient.

4. Oszillatorstruktur nach einem der Ansprüche 1 bis 3,
**dadurch gekennzeichnet,**
**daß** der elektrische Leiter (30) eine Streifenform aufweist.

5. Oszillatorstruktur nach einem der Ansprüche 1 bis 3,
**dadurch gekennzeichnet,**
**daß** der elektrische Leiter eine Mäanderform aufweist.

6. Oszillatorstruktur nach einem der Ansprüche 1 bis 3,
**dadurch gekennzeichnet,**
**daß** der elektrische Leiter eine Spiralform aufweist.

7. Oszillatorstruktur nach einem der Ansprüche 1 bis 6,
**dadurch gekennzeichnet,**
**daß** der Oszillator-Schaltkreis durch eine integrierte elektronische Schaltung (105) gebildet wird.

8. Oszillatorstruktur nach Anspruch 7,
**dadurch gekennzeichnet,**
**daß** die integrierte elektronische Schaltung (105) wenigstens eine Varaktordiode enthält.

9. Oszillatorstruktur nach Anspruch 8,
**dadurch gekennzeichnet,**
**daß** die Varaktordiode mit dem Resonator in einem elektrischen Schwingkreis zusammenwirkt.

10. Oszillatorstruktur nach einem der Ansprüche 1 bis 9,
**dadurch gekennzeichnet,**
**daß** der Oszillator-Schaltkreis wenigstens einen Verstärker enthält.

11. Oszillatorstruktur nach einem der Ansprüche 1 bis 10,
**dadurch gekennzeichnet,**
**daß** der Oszillator-Schaltkreis über eine Klebeschicht (100) mit dem Träger (20) verbunden ist.

12. Oszillatorstruktur nach Anspruch 11,
**dadurch gekennzeichnet,**
**daß** die Klebeschicht (100) den Oszillator-Schaltkreis vom Träger (20) isoliert.

13. Oszillatorstruktur nach einem der Ansprüche 1 bis 12,
**dadurch gekennzeichnet,**
**daß** der Oszillator-Schaltkreis über wenigstens einen Verbindungsdraht (200, 230) mit dem Träger (20) verbunden ist.

14. Oszillatorstruktur nach Anspruch 13,
**dadurch gekennzeichnet,**
**daß** wenigstens ein Verbindungsdraht (230) mit einem Koppelpunkt (35) zum Ein- oder Auskoppeln eines elektrischen Signals verbunden ist.

## Claims

1. Oscillator structure having at least one oscillator circuit and at least one resonator, the oscillator circuit being arranged on a conductive support (20), and the resonator, which is a constituent part of the support, being formed by an exposed electrical conductor (30),
**characterized**
**in that** the electrical conductor (30) forming the resonator is arranged below the oscillator circuit (105).

2. Oscillator structure according to Claim 1,
**characterized**
**in that** the support (20) is a support surface, and in that the electrical conductor (30) is -situated essentially within the support surface.

3. Oscillator structure according to Claim 1 or 2,
**characterized**
**in that** one end of the electrical conductor (30) is connected to the support (20), and in that another end of the electrical conductor (30) is used as a coupling point (35) for inputting or outputting an electrical signal.

4. Oscillator structure according to one of Claims 1 to 3,
**characterized**
**in that** the electrical conductor (30) has a strip shape.

5. Oscillator structure according to one of Claims 1 to 3,
**characterized**
**in that** the electrical conductor has a meander shape.

6. Oscillator structure according to one of Claims 1 to 3,
**characterized**
**in that** the electrical conductor has a spiral shape.

7. Oscillator structure according to one of Claims 1 to 6,
**characterized**
**in that** the oscillator circuit is formed by an integrated electronic circuit (105).

8. Oscillator structure according to Claim 7,
**characterized**
**in that** the integrated electronic circuit (105) contains at least one varactor diode.

9. Oscillator structure according to Claim 8,
**characterized**
**in that** the varactor diode interacts with the resonator in an electrical resonant circuit.

10. Oscillator structure according to one of Claims 1 to 9,
**characterized**
**in that** the oscillator circuit contains at least one amplifier.

11. Oscillator structure according to one of Claims 1 to 10,
**characterized**
**in that** the oscillator circuit is connected to the support (20) by means of an adhesive layer (100).

12. Oscillator structure according to Claim 11,
**characterized**
**in that** the adhesive layer (100) insulates the oscillator circuit from the support (20).

13. Oscillator structure according to one of Claims 1 to 12,
**characterized**
**in that** the oscillator circuit is connected to the support (20) by means of at least one connecting wire (200, 230).

14. Oscillator structure according to Claim 13,
**characterized**
**in that** at least one connecting wire (230) is connected to a coupling point (35) for inputting or outputting an electrical signal.

## Revendications

1. Structure d'oscillateur ayant au moins un circuit (105) oscillateur et au moins un résonateur, le circuit oscillateur étant disposé sur un support (20) conducteur et le résonateur, qui fait partie du support, est formé par un conducteur (30) électrique mis à nu,
**caractérisée,**
**en ce que** le conducteur (30) électrique formant le résonateur est disposé sous le circuit (105) oscillateur.

2. Structure d'oscillateur suivant la revendication 1,
**caractérisée,**
**en ce que** le support (20) est une surface formant support et en ce que le conducteur (30) électrique se trouve sensiblement à l'intérieur de la surface formant support.

3. Structure d'oscillateur suivant la revendication 1 ou 2,
**caractérisée,**
**en ce qu'**une extrémité du conducteur (30) électrique est reliée au support (20) et en ce qu'une autre extrémité du conducteur (30) électrique sert de point (35) de couplage pour l'entrée ou la sortie d'un signal électrique.

4. Structure d'oscillateur suivant l'une des revendications 1 à 3,
**caractérisée,**
**en ce que** le conducteur (30) électrique a une forme en ruban.

5. Structure d'oscillateur suivant l'une des revendications 1 à 3,
**caractérisée,**
**en ce que** le conducteur électrique a une forme sinueuse.

6. Structure d'oscillateur suivant l'une des revendications 1 à 3,
**caractérisée,**
**en ce que** le conducteur électrique a une forme en spirale.

7. Structure d'oscillateur suivant l'une des revendications 1 à 6,
**caractérisée,**
**en ce que** le circuit oscillateur est formé par un circuit (35) électronique intégré.

8. Structure d'oscillateur suivant la revendication 7,
**caractérisée,**
**en ce que** le circuit (105) électronique intégré comporte au moins une diode varactor.

9. Structure d'oscillateur suivant la revendication 8,
**caractérisée,**
**en ce que** la diode varactor coopère avec le résonateur dans un circuit oscillant électrique.

10. Structure d'oscillateur suivant l'une des revendications 1 à 9,
**caractérisée,**
**en ce que** le circuit d'oscillateur comprend au moins un amplificateur.

11. Structure d'oscillateur suivant l'une des revendications 1 à 10,
**caractérisée,**
**en ce que** le circuit oscillateur est relié au support (20) par une couche (100) de colle.

12. Structure d'oscillateur suivant la revendication 11,
**caractérisée,**
**en ce que** la couche (100) de colle isole le circuit oscillateur du support (20).

13. Structure d'oscillateur suivant l'une des revendications 1 à 12,
**caractérisée,**
**en ce que** le circuit oscillateur est relié au support (20) par au moins un fil (200, 230) de liaison.

14. Structure d'oscillateur suivant la revendication 13,
**caractérisée,**
**en ce qu'**au moins un fil (230) de liaison est relié à un point (35) de couplage pour l'entrée ou la sortie d'un signal électrique.
